# EUROPÄISCHE PATENTSCHRIFT

(11) **EP 2 732 488 B1**
(45) Veröffentlichungstag und Bekanntmachung des Hinweises auf die Patenterteilung: **31.05.2017**
(21) Anmeldenummer: 12740534.8
(22) Anmeldetag: 13.07.2012
(51) Int. Cl.: H01M 2/20, H01M 10/48, H01M 10/42, H01R 13/66, G01R 31/36, G01R 1/20, H01R 11/28

(54) **VORRICHTUNG ZUM FÜHREN EINES ELEKTRISCHEN STROMES**
DEVICE FOR CONDUCTING AN ELECTRIC CURRENT
DISPOSITIF SERVANT À GUIDER UN COURANT ÉLECTRIQUE

(30) Priorität: 14.07.2011 DE 102011079167
(43) Veröffentlichungstag der Anmeldung: 21.05.2014
(73) Patentinhaber: Continental Teves AG&Co. Ohg, 60488 Frankfurt (DE)
(72) Erfinder: JÖCKEL, Wolfgang, 36129 Gersfeld (DE); RINK, Klaus, 63517 Rodenbach (DE)
(86) Internationale Anmeldenummer: PCT/EP2012/063858
(87) Internationale Veröffentlichungsnummer: WO 2013/007834

(56) Entgegenhaltungen:
- DE-A1- 10 118 027
- DE-A1-102005 043 320
- DE-A1-102006 058 879
- DE-C1- 10 223 977
- DE-T5-112008 001 413

## Beschreibung

Die Erfindung betrifft eine Vorrichtung zum Führen eines elektrischen Stromes auf einem Strompfad zwischen einem an eine Fahrzeugbatterie angeschlossenen elektrischen Verbindungskabel und der Fahrzeugbatterie sowie ein Fahrzeug mit der Vorrichtung.

Zur Durchführung von Messungen eines von einer elektrischen Energiequelle an einen elektrischen Verbraucher abgegebenen elektrischen Stromes in einem Kraftfahrzeug können in Reihe zwischen die elektrische Energiequelle und den elektrischen Verbraucher ein Stromsensor geschaltet werden. Ein derartiger Stromsensor ist beispielsweise aus der

DE 10 2011 078 548 A1 oder der DE 10 2005 043 320 A1 bekannt.

Es ist Aufgabe der vorliegenden Erfindung die Strommessungen zu verbessern.

Die Aufgabe wird durch die Merkmale der unabhängigen Ansprüche gelöst. Bevorzugte Weiterbildungen sind Gegenstand der abhängigen Ansprüche.

Die Erfindung schlägt eine Vorrichtung zum Führen eines elektrischen Stromes auf einem Strompfad zwischen einem an eine Fahrzeugbatterie angeschlossenen elektrischen Verbindungskabel und der Fahrzeugbatterie vor, wobei der Strompfad durch eine elektrische Unterbrechung in zwei Strompfadteile aufgeteilt ist, die über einen Stromsensor elektrisch miteinander verbunden sind. Die Vorrichtung ist eingerichtet, das Verbindungskabel und die Fahrzeugbatterie einerseits mechanisch zu verbinden und andererseits den elektrischen Kontakt zwischen den beiden Strompfadteilen über den Stromsensor herstellen, so dass der Stromsensor einen über die beiden Strompfadteile fließenden Strom erfassen kann. Erfindungsgemäß ist die mechanische Verbindung von der elektrischen Verbindung unabhängig, das heißt entkoppelt. Die erfindungsgemäße Vorrichtung ist dadurch gekennzeichnet, dass die elektrische Unterbrechung eine Leiterbahn als Strompfad dabei in einen ersten Leiterbahnteil als ersten Strompfadteil und in einen zweiten Leiterbahnteil als zweiten Strompfadteil unterteilt, wobei auf dem ersten und dem zweiten Leiterbahnteil jeweils ein Leistungsfeldeffekttransistor getragen wird, der Teil eines aktiven Shunts als Stromsensor ist, wobei die beiden Leiterbahnteile an der elektrischen Unterbrechung zahnförmig ineinander greifen. Der Erfindung liegt die Überlegung zugrunde, dass die mechanische Verbindung zwischen der Fahrzeugbatterie und dem Verbindungskabel und deren elektrische Verbindung über den Stromsensor auch als gemeinsame technische Einheit oder abhängig voneinander aufgebaut werden könnte. Die Erfindung erkennt jedoch, dass mechanische Belastungen, wie Wärmearbeit, auf die mechanische Verbindung auf diese Weise auch unmittelbare Auswirkungen auf die elektrische Verbindung hätten. Wird die elektrische Verbindung im schlimmsten Falle unterbrochen, so wäre jedoch nicht nur die Strommessung davon betroffen, sondern auch die elektrische Energieversorgung eines an das elektrische Verbindungskabel angeschlossenen Verbrauchers aus der Fahrzeugbatterie.

Durch die voneinander unabhängige elektrische und mechanische Verbindung wird damit vermieden, dass mechanische Belastungen auf die mechanische Verbindung Auswirkungen auf die elektrische Verbindung haben und umgekehrt.

Die Erfindung gibt daher eine Vorrichtung zum Führen eines elektrischen Stromes auf einem Strompfad zwischen einem an eine Fahrzeugbatterie angeschlossenen elektrischen Verbindungskabel und der Fahrzeugbatterie an, wobei der Strompfad durch eine elektrische Unterbrechung in zwei Strompfadteile aufgeteilt ist, die über einen Stromsensor elektrisch miteinander verbunden sind. Die angegebene Vorrichtung umfasst
- ein mechanisches Verbindungselement zum mechanischen Verbinden der Fahrzeugbatterie und dem Verbindungskabel und
- ein vom mechanischen Verbindungselement verschiedenes elektrisches Verbindungselement zum elektrischen Verbinden des Stromsensors mit einem der Strompfadteile.

Die Strompfadteile als auch der Stromsensor können dabei Teil der angegebenen Vorrichtung sein. Durch die angegebene Vorrichtung werden die elektrische Verbindung zwischen den Strompfadteilen und damit die elektrische Strommessung zuverlässiger.

In einer Weiterbildung umfasst die angegebene Vorrichtung den Stromsensor, der auf dem mechanischen Verbindungselement getragen ist, so dass eine mechanische Stabilität des mechanischen Verbindungselementes zum mechanischen Stützen und Stabilisieren des Stromsensors verwendet werden kann.

Alternativ oder zusätzlich umfasst die angegebene Vorrichtung ein erstes der Strompfadteile, das auf dem mechanischen Verbindungselement als Leiterbahn ausgebildet ist. Auf diese Weise kann eine mechanische Stabilität des mechanischen Verbindungselementes zur mechanischen Stabilisierung des ersten Strompfadteils mit verwendet werden.

Besonders bevorzugt kann der Stromsensor dabei auf dem ersten der Strompfadteile mechanisch getragen und mit diesen über eine weitere elektrische Verbindung elektrisch verbunden sein. Auf diese Weise kann die angegebene Vorrichtung als funktionsfähiges Strommessgerät zwischen der Fahrzeugbatterie und dem Verbindungskabel implementiert werden.

In einer besonderen Weiterbildung umfasst die angegebene Vorrichtung ein Entlastungselement zum Reduzieren einer über das Verbindungskabel auf das mechanische Verbindungselement eingebrachten Zugbelastung. Auf diese Weise wird die zwischen dem Verbindungskabel und der Fahrzeugbatterie verbaute Vorrichtung weiter mechanisch stabilisiert.

In einer zusätzlichen Weiterbildung umfasst die angegebene Vorrichtung eine wenigstens einen Teils des Strompfades führende elektrische Polklemme, zum Verbinden des mechanischen Verbindungselementes mit einem elektrischen Pol der Fahrzeugbatterie. Eine derartige Polklemme ist zum lösbaren elektrischen und mechanischen Anschluss an einen Pol der Fahrzeugbatterie vorgesehen, so dass die angegebene Vorrichtung auf einfache Weise an der Fahrzeugbatterie gehalten werden kann.

In einer besonderen Weiterbildung der angegebenen Vorrichtung ist der Stromsensor auf der Polklemme mechanisch getragen und mit dem durch die Polklemme geführten Strompfad elektrisch kontaktiert. Auf diese Weise kann eine mechanische Stabilität der Polklemme zum mechanischen Stabilisieren des Stromsensors verwendet werden.

In einer besonders bevorzugten Weiterbildung der angegebenen Vorrichtung ist das mechanische Verbindungelement elektrisch isoliert an der Polklemme gehalten. Auf diese Weise kann die elektrische Unterbrechung durch die elektrische Isolierung zwischen der Polklemme und dem mechanischen Verbindungselement in einfacher Weise realisiert werden.

In einer anderen besonders bevorzugten Weiterbildung der angegebenen Vorrichtung ist das mechanische Verbindungelement formschlüssig in der Polklemme gehalten. Auf diese Weise kann das mechanische Verbindungselement nicht nur in einfacher Weise zwischen der Fahrzeugbatterie und dem Verbindungskabel verbaut werden, das mechanische Verbindungselement lässt sich auch in einfacher Weise zu Wartungszwecken aus der Polklemme aus und in diese wieder einbauen.

In einer alternativen Weiterbildung der angegebenen Vorrichtung umfasst das mechanische Verbindungselement ein den Strompfad führendes Anschlusselement zur elektrischen und mechanischen Verbindung des Verbindungskabels mit dem mechanischen Verbindungselement, so dass das Verbindungskabel in einfacher Weise mit der angegebenen Vorrichtung nicht nur elektrisch sondern auch mechanisch verbunden werden kann. Das Anschlusselement kann dabei beispielsweise ein Stecker oder eine Steckeraufnahme sein.

Die Erfindung gibt auch eine Fahrzeugbatterie an, die einen elektrischen Anschluss zum Abgeben oder Aufnehmen eines elektrischen Stromes an einen elektrischen Verbraucher beziehungsweise von einer elektrischen Energiequelle und eine angegebene Vorrichtung umfasst, die an den elektrischen Anschluss angeschlossen ist.

Die Erfindung gibt auch ein Fahrzeug an, das
- eine Fahrzeugbatterie,
- einen über ein Verbindungskabel an die Fahrzeugbatterie angeschlossenen elektrischen Verbraucher und
- eine der angegebenen Vorrichtungen umfasst, die zwischen das Verbindungskabel und die Fahrzeugbatterie geschaltet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines ersten Ausführungsbeispiels der angegebenen Vorrichtung;
Fig. 2 eine schematische Ansicht eines zweiten Ausführungsbeispiels der angegebenen Vorrichtung; und
Fig. 3 eine schematische Ansicht eines dritten Ausführungsbeispiels der angegebenen Vorrichtung zeigen.

In den Figuren werden gleiche technische Elemente mit gleichen Bezugszeichen versehen und nur einmal beschrieben.

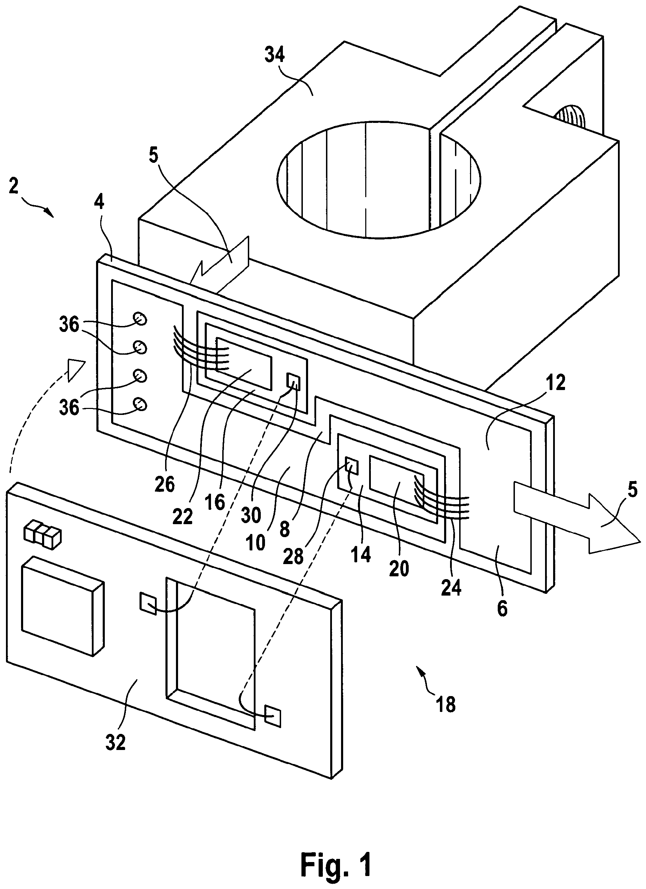

Es wird auf Fig. 1 Bezug genommen, die eine schematische Ansicht eines ersten Ausführungsbeispiels der angegebenen Vorrichtung 2 zeigt.

Die Vorrichtung 2 weist in der vorliegenden Ausführung als mechanisches Verbindungselement eine Leiterplatte 4 auf, auf der als Pfad für einen Strom 5 eine Leiterbahn 6 mit einer elektrischen Unterbrechung 8 geführt ist. Die elektrische Unterbrechung 8 teilt die Leiterbahn 6 damit in einen ersten Leiterbahnteil 10 als ersten Strompfadteil und in einen zweiten Leiterbahnteil 12 als zweiten Strompfadteil.

Auf dem ersten und dem zweiten Leiterbahnteil 10, 12 ist jeweils ein aus der DE 10 2011 078 548 A1 bekannter Leistungsfeldeffekttransistor 14, 16, nachstehend FET 14, 16 genannt, getragen, der Teil eines in der genannten Druckschrift offenbarten aktiven Shunts 18 ist. Ein in der vorliegenden Darstellung nicht weiter sichtbare Source-Anschluss des ersten FETS 14 und ein in der vorliegenden Darstellung nicht weiter sichtbarer Drain-Anschluss des zweiten FETs 16 sind in der vorliegenden Ausführung jeweils mit den Leiterbahnteilen 10, 12 elektrisch kontaktiert, auf denen die FETs 14, 16 getragen sind. Ein Drain-Anschluss 20 des ersten FETs 14 und ein Source-Anschluss 16 des zweiten FETs 16 ist jeweils an eine elektrische Verbindung 24, 26 angeschlossen, die in der vorliegenden Ausführung jeweils als eine Vielzahl von Bond-Drähten ausgeführt ist. Mit der elektrischen Verbindung 24, 26 wird der freie Source- beziehungsweise Drain-Anschluss 20, 22 eines FETs 14, 16 jeweils mit dem Leiterbahnteil 10, 12 elektrisch verbunden, auf dem der entsprechende FET 14, 16 nicht getragen ist. Auf diese Weise überbrücken die FETs 14, 16 gemeinsam mit der elektrischen Verbindung 24, 26 die beiden Leiterbahnteile 10, 12 und stellen so die geschlossene Leiterbahn 6 über die Leiterplatte 4 her.

Wie in der DE 10 2011 078 548 A1 näher erläutert, sind die beiden FETs 14, 16 zwischen den beiden Leiterbahnteilen 10, 12 verschaltet, um einen durch die Leiterbahn 6 fließenden Strom in zwei verschiedene Stromrichtungen zu messen. Dazu sind an die Gate-Anschlüsse 28, 30 der FETs 14, 16 eine Auswerteschaltung 32 angeschlossen, deren Aufbau beispielsweise gleich dem Aufbau der Auswerteschaltung in der DE 10 2011 078 548 A1 sein kann.

Der zwischen die beiden Leiterbahnteile 10, 12 verschaltete aktive Shunt 18 soll in der vorliegenden Ausführung beispielhaft einen Stromsensor darstellen, der beispielsweise zum Messen eines Lade- und Entladestromes zu oder aus einer Fahrzeugbatterie herangezogen werden könnte. Alternativ kann zwischen den beiden Leiterbahnteilen 10, 12 auch ein passiver Shunt verschaltet werden.

In der vorliegenden Ausführung greifen die beiden Leiterbahnteile 10, 12 an der elektrischen Unterbrechung 8 zahnförmig ineinander, so dass an dieser Stelle weitere FETs zum Messen des elektrischen Stromes durch die Leiterbahn 8 angeordnet werden könnten.

Die Leiterplatte 4 ist in der vorliegenden Ausführung mechanisch mit einer Polklemme 34 verbunden, die in einer dem Fachmann bekannten Weise zum elektrischen Kontaktieren eines nicht weiter dargestellten Pols einer Fahrzeugbatterie verwendet werden kann. Die mechanische Verbindung zwischen der Leiterplatte 4 und der Polklemme 34 kann zwar beliebig ausgestaltet sein, für einen möglichst geringen Montageaufwand sollte diese mechanische Verbindung jedoch auch die elektrische Verbindung zwischen der Polklemme 34 und der Leiterbahn 6 herstellen, damit die Leiterbahn 6 aus der Polklemme 34 den Strom 5 aufnehmen kann. Dazu kann die mechanische Verbindung in der vorliegenden Ausführung bevorzugt als PressFit-Verbindung ausgeführt sein. Für die PressFit-Verbindung sind durch die die Leiterbahn 6 und die Leiterplatte 4 Durchgangsöffnungen 36 geführt, die in einer dem Fachmann bekannten Weise von PressFit-Pins der PressFit-Verbindung durchstoßen sind.

Auf der den Durchgangsöffnungen 36 gegenüberliegenden Seite der Leiterbahn 6 kann diese elektrisch mit einem nicht weiter dargestellten Verbindungskabel kontaktiert werden, so dass der elektrische Strom 5 über das Verbindungskabel zu einem oder mehreren elektrischen Verbrauchern geführt werden kann. Zusätzlich sollte das Verbindungskabel mechanisch mit einem von der Leiterplatte 4 unabhängigen Element, wie dem Polschuh 34 oder einem Gehäuse der Leiterplatte 4 mechanisch verbunden werden, damit auf leiterplatte 4 über die elektrische Kontaktierung zwischen der Leiterbahn 6 und dem Verbindungskabel keine mechanischen Belastungen, wie Zugbelastungen eingebracht werden können, die die FETs 14, 16 mechanisch verspannen und damit beschädigen könnten. Dazu kann das Verbindungskabel an dem oben genannten von der Leiterplatte 4 unabhängigen Element durch eine Klemm, Klebe- oder umspritzte/ummoldete Verbindung mechanisch befestigt werden.

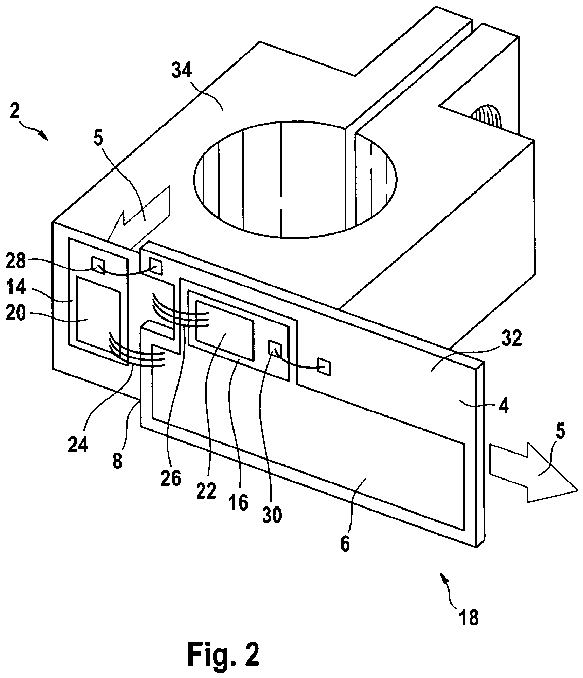

Es wird auf Fig. 2 Bezug genommen, die eine schematische Ansicht eines zweiten Ausführungsbeispiels der angegebenen Vorrichtung 2 zeigt.

In der Vorrichtung 2 der Fig. 2 wird als elektrische Unterbrechung 8 die ohnehin vorhandene mechanische Trennung zwischen der Leiterplatte 4 und der Polklemme 34 herangezogen. Damit stellt die Polklemme 34 den ersten der oben genannten Strompfadteile und die Leiterbahn 6 auf der Leiterplatte 4 den zweiten der oben genannten Strompfadteile dar. Auf diese Weise kann die Leiterplatte platzsparender und kostengünstiger hergestellt werden.

In der vorliegenden Ausführung ist der nicht gezeigte Source-Anschluss des ersten FETs 14 mit der Oberfläche der Polklemme 34 elektrisch kontaktiert, wobei der erste FET 14 auch mechanisch von der Polklemme 34 getragen wird. Der Drain-Anschluss 20 des ersten FETs 14 wird über die als Bond-Drähte ausgeführte elektrische Verbindung 24 mit der Leiterbahn 6 auf der Leiterplatte 4 elektrisch kontaktiert. In analoger Weise ist der nicht gezeigte Drain-Anschluss des zweiten FETs 16 mit der Leiterbahn 6 kontaktiert, wobei der zweite FET 16 von der Leiterplatte 4 mechanisch getragen wird. Der Source-Anschluss 22 des zweiten FETs 16 ist über die als Bond-Drähte ausgeführte elektrische Verbindung 26 mit der Oberfläche der Polklemme 34 elektrisch kontaktiert.

Um eine optimale elektrische Kontaktierung mit der Oberfläche der Polklemme 34 zu gewährleisten kann diese eine geeignete Beschichtung, wie beispielsweise mit einer Legierung aus Kupfer, Nickel und Gold (CuNiAu). Alternativ kann die Polklemme 34 auch selbst aus einem für die elektrislche Kontaktierung geeigneten Material, wie beispielsweise Aluminium (Al) ausgebildet sein.

Mechanisch kann die Leiterplatte 4 in jeder beliebigen Art und Weise auf der Polklemme 34 gehalten werden. So kann analog zu Fig. 1 eine PressFit-Verbindung zum Einsatz kommen, oder die Leiterplatte 4 kann beispielsweise auf der Polklemme 34 verklebt, verschraubt oder vernietet werden. Es ist bei der Befestigung der Leiterplatte 4 auf der Polklemme 34 zu achten, dass die Leiterbahn 6 elektrisch von der Polklemme 34 getrennt bleibt, um die elektrische Unterbrechung 8 nicht zu überbrücken.

Bei der Vorrichtung 2 der vorliegenden Ausführung können beim Anschluss des Verbindungskabels an die Leiterbahn 6 die gleichen Überlegungen zur Vermeidung mechanischer Spannungen und Beschädigungen des zweiten FETs 16 auf der Leiterplatte angewendet werden, wie bei der Vorrichtung 2 der Fig. 1, worauf der Kürze halber nachstehend nicht weiter eingegangen werden soll.

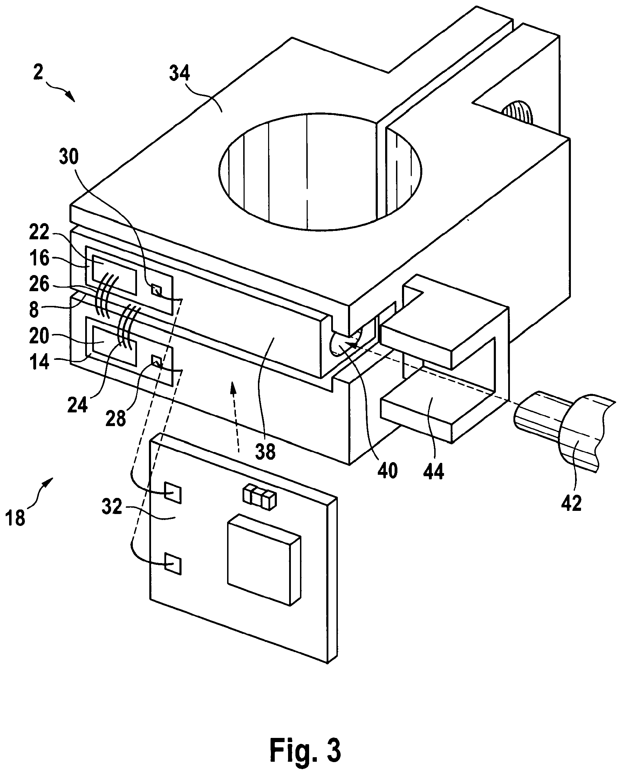

Es wird auf Fig. 3 Bezug genommen, die eine schematische Ansicht eines dritten Ausführungsbeispiels der angegebenen Vorrichtung 2 zeigt.

Bei der Vorrichtung 2 der Fig. 3 ist die Leiterplatte 4 mit der Leiterbahn 6 aus Fig. 2 einstückig als ein massiver Tragekörper 38 ausgebildet, der formschlüssig in die Polklemme 34 eingesetzt ist. Der massive Tragekörper 38 ist zum einen elektrisch leitfähig und zum anderen gegen die Polklemme 34 elektrisch isoliert. Der elektrische Anschluss der beiden FETs 14, 16 ist in der gleichen Weise ausgebildet, wie in Fig. 2, wobei die Leiterbahn 6 hier wie bereits erwähnt durch den massiven Tragekörper 38 ersetzt ist. Der Tragekörper 38 und/oder die Polklemme 34 können zur elektrischen Kontaktierung der FETs 14, 16 und der elektrischen Verbindungen 24, 26 analog zur Vorrichtung 2 der Fig. 2 geeignet beschichtet oder aus einem entsprechend geeigneten Material gefertigt sein.

Der massive Tragekörper 38 weist in der vorliegenden Ausführung eine Aufnahmeöffnung 40 auf, in die das Verbindungskabel, das in Fig. 3 gezeigt und mit dem Bezugszeichen 42 versehen ist, eingeführt und mit dem massiven Tragekörper 38 elektrisch und mechanisch kontaktiert werden kann. Die elektrische und mechanische Kontaktierung kann dabei in Form einer Presspassung, durch Löten oder in jeder anderen Weise erreicht werden.

Zur Zugentlastung des Verbindungskabels 42 ist in der vorliegenden Ausführung eine Fixierung 44 montiert, die Zugkräfte aus dem Verbindungskabel 42 direkt in die Polklemme 34 einleitet.

Mit der Vorrichtung 2 gemäß Fig. 3 lässt sich der Stromsensor in der beispielhaften Form des aktiven Shunts 18 auf engstem Raum mit den wenigsten Kontaktierungsstellen zwischen dem Verbindungskabel 42 und einer Fahrzeugbatterie verschalten, wodurch der niedrigste elektrische Widerstand erreicht ist. Zudem ist eine eigene Leiterplatte obsolet. Darüber hinaus lässt sich die Vorrichtung 2 in einfacher Weise zusammensetzen und auch wieder auseinandernehmen, da der massive Tragekörper 38 formschlüssig in die Polklemme 34 eingesetzt ist.

## Patentansprüche

1. Vorrichtung (2) zum Führen eines elektrischen Stromes (5) auf einem Strompfad (6) zwischen einem an eine Fahrzeugbatterie angeschlossenen elektrischen Verbindungskabel (42) und der Fahrzeugbatterie, wobei der Strompfad (6) durch eine elektrische Unterbrechung (8) in zwei Strompfadteile (10, 12) aufgeteilt ist, die über einen Stromsensor (18) elektrisch miteinander verbunden sind, umfassend
- ein mechanisches Verbindungselement (4, 38) zum mechanischen Verbinden der Fahrzeugbatterie und dem Verbindungskabel (42) und
- ein vom mechanischen Verbindungselement (4, 38) verschiedenes elektrisches Verbindungselement (24, 26) zum elektrischen Verbinden des Stromsensors (18) mit einem der Strompfadteile (10, 12), **dadurch gekennzeichnet, dass** die elektrische Unterbrechung (8) eine Leiterbahn (6) als Strompfad dabei in einen ersten Leiterbahnteil (10) als ersten Strompfadteil und in einen zweiten Leiterbahnteil (12) als zweiten Strompfadteil unterteilt, wobei auf dem ersten und dem zweiten Leiterbahnteil (10, 12) jeweils ein Leistungsfeldeffekttransistor (14, 16,) getragen wird, der Teil eines aktiven Shunts (18) als Stromsensor ist,
wobei die beiden Leiterbahnteile (10, 12) an der elektrischen Unterbrechung zahnförmig ineinander greifen.

2. Vorrichtung (2) nach Anspruch 1, umfassend den Stromsensor (18), der auf dem mechanischen Verbindungselement (4, 38) getragen ist.

3. Vorrichtung (2) nach Anspruch 2, wobei der Stromsensor (18) auf dem ersten der Strompfadteile (10, 12) mechanisch getragen und mit diesen über eine weitere elektrische Verbindung elektrisch verbunden ist.

4. Vorrichtung (2) nach einem der vorstehenden Ansprüche, umfassend ein Entlastungselement (44) zum Reduzieren einer über das Verbindungskabel (42) auf das mechanische Verbindungselement (4, 38) eingebrachten Zugbelastung.

5. Vorrichtung (2) nach einem der vorstehenden Ansprüche, umfassend eine wenigstens einen Teil des Strompfades (6) führende elektrische Polklemme (34), zum Verbinden des mechanischen Verbindungselementes (4, 38) mit einem elektrischen Pol der Fahrzeugbatterie.

6. Vorrichtung (2) nach Anspruch 5, wobei der Stromsensor (18) auf der Polklemme (34) mechanisch getragen und mit dem durch die Polklemme (34) geführten Strompfad (6) elektrisch kontaktiert ist.

7. Vorrichtung (2) nach Anspruch 5 oder 6, wobei das mechanische Verbindungelement (4, 38) formschlüssig und/oder elektrisch isoliert in beziehungsweise an der Polklemme (34) gehalten ist.

8. Vorrichtung (2) nach einem der vorstehenden Ansprüche, wobei das mechanische Verbindungselement (4, 38) ein den Strompfad (6) führendes Anschlusselement (40) zur elektrischen und mechanischen Verbindung des Verbindungskabels (42) mit dem mechanischen Verbindungselement (4, 38) umfasst.

9. Fahrzeugbatterie umfassend
- einen elektrischen Anschluss zum Abgeben oder Aufnehmen eines elektrischen Stromes an einen elektrischen Verbraucher beziehungsweise von einer elektrischen Energiequelle, und
- eine Vorrichtung (2) nach einem der vorstehenden Ansprüche, die an den elektrischen Anschluss angeschlossen ist.

## Claims

1. Apparatus (2) for carrying an electric current (5) on a current path (6) between an electrical connecting cable (42), which is connected to a vehicle battery, and the vehicle battery, wherein the current path (6) is split by an electrical interruption (8) into two current path parts (10, 12) which are electrically connected to one another by means of a current sensor (18), comprising
- a mechanical connecting element (4, 38) for mechanically connecting the vehicle battery to the connecting cable (42), and
- an electrical connecting element (24, 26), which is different from the mechanical connecting element (4, 38), for electrically connecting the current sensor (18) to one of the current path parts (10, 12), **characterized in that** the electrical interruption (8) subdivides a conductor track (6) as current path in this case into a first conductor track part (10) as first current path part and into a second conductor track part (12) as second current path part, wherein a respective power field-effect transistor (14, 16) is supported on the first and the second conductor track part (10, 12), the said power field-effect transistor being part of an active shunt (18) as current sensor, wherein the two conductor track parts (10, 12) engage in one another in the manner of teeth at the electrical interruption.

2. Apparatus (2) according to Claim 1, comprising the current sensor (18) which is supported on the mechanical connecting element (4, 38).

3. Apparatus (2) according to Claim 2, wherein the current sensor (18) is mechanically supported on the first of the current path parts (10, 12) and is electrically connected to the said current path part by means of a further electrical connection.

4. Apparatus (2) according to one of the preceding claims, comprising a relief element (44) for reducing a tensile loading which is introduced onto the mechanical connecting element (4, 38) by means of the connecting cable (42).

5. Apparatus (2) according to one of the preceding claims, comprising an electrical pole terminal (34) which carries at least a portion of the current path (6), for connecting the mechanical connecting element (4, 38) to an electrical pole of the vehicle battery.

6. Apparatus (2) according to Claim 5, wherein the current sensor (18) is mechanically supported on the pole terminal (34) and is electrically contacted by the current path (6) which is carried by the pole terminal (34).

7. Apparatus (2) according to Claim 5 or 6, wherein the mechanical connecting element (4, 38) is held in or on the pole terminal (34) in an interlocking and/or electrically insulated manner.

8. Apparatus (2) according to one of the preceding claims, wherein the mechanical connecting element (4, 38) comprises a connection element (40), which carries the current path (6), for electrically and mechanically connecting the connecting cable (42) to the mechanical connecting element (4, 38).

9. Vehicle battery comprising
- an electrical connection for outputting or receiving an electric current to an electrical load or from an electrical energy source, and
- an apparatus (2) according to one of the preceding claims which is connected to the electrical connection.

## Revendications

1. Dispositif (2) pour conduire un courant électrique (5) sur un trajet de courant (6) entre un câble de raccordement électrique (42) raccordé à une batterie de véhicule et la batterie de véhicule, le trajet de courant (6) étant divisé par une interruption électrique (8) en deux parties de trajet de courant (10, 12) qui sont reliées électriquement entre elles par le biais d'un capteur de courant (18), comprenant
- un élément de liaison mécanique (4, 38) destiné à relier mécaniquement la batterie de véhicule et le câble de raccordement (42) et
- un élément de liaison électrique (24, 26), différent de l'élément de liaison mécanique (4, 38), destiné à relier électriquement le capteur de courant (18) à l'une des parties de trajet de courant (10, 12), **caractérisé en ce que** l'interruption électrique (8) divise ici une piste conductrice (6) faisant office de trajet de courant en une première partie de piste conductrice (10) faisant office de première partie de trajet de courant et en une deuxième partie de piste conductrice (12) faisant office de deuxième partie de trajet de courant, un transistor à effet de champ de puissance (14, 16) étant respectivement supporté sur la première et la deuxième partie de piste conductrice (10, 12), lequel fait partie d'un shunt actif (18) en tant que capteur de courant,
les parties de piste conductrice (10, 12) venant en prise l'une dans l'entre en forme de dent au niveau de l'interruption électrique.

2. Dispositif (2) selon la revendication 1, comprenant le capteur de courant (18) qui est supporté sur l'élément de liaison mécanique (4, 38).

3. Dispositif (2) selon la revendication 2, le capteur de courant (18) étant supporté mécaniquement sur la première des parties de piste conductrice (10, 12) et relié électriquement à celle-ci par le biais d'une liaison électrique supplémentaire.

4. Dispositif (2) selon l'une des revendications précédentes, comprenant un élément de décharge (44) destiné à réduire une contrainte de traction appliquée à l'élément de liaison mécanique (4, 38) par le biais du câble de raccordement (42).

5. Dispositif (2) selon l'une des revendications précédentes, comprenant une borne polaire (34) qui conduit au moins une partie du trajet de courant (6), destinée à relier l'élément de liaison mécanique (4, 38) à un pôle électrique de la batterie de véhicule.

6. Dispositif (2) selon la revendication 5, le capteur de courant (18) étant supporté mécaniquement sur la borne polaire (34) et étant mis en contact électrique avec le trajet de courant (6) conduit à travers la borne polaire (34).

7. Dispositif (2) selon la revendication 5 ou 6, l'élément de liaison mécanique (4, 38) étant maintenu par complémentarité de formes et/ou de manière électriquement isolée dans ou sur la borne polaire (34).

8. Dispositif (2) selon l'une des revendications précédentes, l'élément de liaison mécanique (4, 38) comprenant un élément de raccordement (40) conduisant le trajet de courant (6) destiné à la liaison électrique et mécanique du câble de raccordement (42) avec l'élément de liaison mécanique (4, 38).

9. Batterie de véhicule, comprenant
- une borne électrique destinée à délivrer ou à recevoir un courant électrique à un consommateur électrique ou de la part d'une source d'énergie électrique, et
- un dispositif (2) selon l'une des revendications précédentes qui est raccordé à la borne électrique.
